# FASCICULE DE BREVET EUROPEEN

(11) **EP 3 697 727 B1**
(45) Date de publication et mention de la délivrance du brevet: **07.06.2023**
(21) Numéro de dépôt: 18786360.0
(22) Date de dépôt: 19.10.2018
(51) Int. Cl.: B81C 99/00, B81C 1/00

(54) **PROCEDE DE FABRICATION D'UN DISPOSITIF MICROSTRUCTURE**
VERFAHREN ZUR HERSTELLUNG EINER MIKROSTRUKTURIERTEN VORRICHTUNG
METHOD FOR MANUFACTURING A MICROSTRUCTURED DEVICE

(30) Priorité: 19.10.2017 FR 1759832
(43) Date de publication de la demande: 26.08.2020
(73) Titulaire: Commissariat à l'Energie Atomique et aux Energies Alternatives, 75015 Paris (FR); Université de Versailles Saint-Quentin-en-Yvelines, 78035 Versailles Cédex (FR)
(72) Inventeur: MALLOGGI, Florent, 75014 Paris (FR); BROSSARD, Rémy, 94200 Ivry sur Seine (FR)
(74) Mandataire: Gevers & Orès
(86) Numéro de dépôt international: PCT/EP2018/078796
(87) Numéro de publication internationale: WO 2019/077144

(56) Documents cités:
- WO-A1-2005/084581
- US-A- 5 303 141
- US-A- 5 340 433
- US-A1- 2005 151 285
- US-A1- 2014 183 044
- US-B1- 6 561 616

## Description

L'invention concerne le domaine des dispositifs microstructurés.

Plus précisément, l'invention propose un procédé de fabrication d'un dispositif microstructuré, notamment un dispositif microfluidique.

Il existe différentes techniques pour fabriquer des dispositifs microstructurés.

Parmi ces techniques, on peut citer la microfabrication, qui couvre notamment le micro-usinage ou la photolithographie. Le micro-usinage consiste à usiner directement une microstructure (par exemple un canal pour les applications microfluidiques, ou une cavité pour d'autres applications) dans un matériau plastique. Le matériau plastique est ensuite collé à un substrat pour former les canaux. La photolithographie reprend les techniques classiques de la microélectronique. On peut par exemple se référer à C. Iliescu, Microfluidics in Glass : Technologies and Applications. Informacije MIDEM 36(2006), vol. 4 ou à Y. Xia & al., Soft lithography, Angew. Chem. Int. Ed. 1998, vol. 37, pp. 550-575, selon la nature du substrat.

Plus récemment, il a été proposé de s'appuyer sur les possibilités offertes par l'impression, en particulier l'impression par jet d'encre. On pourra par exemple se référer à N. Bhattacharjee & al., Lab Chip, 2016, vol. 16, pp. 1720-1742 pour identifier les différentes sous-techniques susceptibles d'être classées dans la technique d'impression.

Parmi ces sous-techniques entrant dans le cadre de l'impression, l'impression par jet d'encre, ou ce qui revient sensiblement au même, l'impression par l'intermédiaire d'une seringue comportant l'encre, est largement utilisée. Ici, l'idée est de déposer sur un substrat, une encre destinée à se solidifier et à former un motif en négatif d'une microstructure (par exemple un canal pour les applications microfluidiques) du dispositif en cours de fabrication. Le motif et le substrat sont ensuite recouverts par une enveloppe. Puis, le ou chaque motif en négatif est éliminé. Il reste alors l'enveloppe sur le substrat, la microstructure étant alors formée dans l'enveloppe.

Ici, l'étape critique réside dans l'élimination du motif, nécessaire pour réaliser la microstructure.

Une approche classique pour éliminer le motif consiste à appliquer un jet de fluide (eau, notamment) sous haute pression. Le problème de cette approche est qu'elle implique des contraintes mécaniques sur le substrat et sur l'enveloppe, et en particulier au niveau de l'interface entre l'enveloppe et le substrat. On peut donc desceller le dispositif microstructuré et si ce n'est pas le cas, le déformer.

Par ailleurs, cette approche ne peut fonctionner que pour des applications microfluidiques (présence d'un canal et en conséquence d'ouvertures permettant l'évacuation du motif par le jet de fluide. Autrement dit, cette approche n'est pas applicable lorsque le motif sert à former une cavité, comme cela peut être le cas pour d'autres applications (optique, par exemple).

Une autre approche consiste à employer un motif particulier.

Ainsi, l'article de Thierrault et al, « Chaotic mixing in three-dimensional microvascular networks fabricated by direct-write assembly », Nature materials, vol. 2, Avril 2003, pp. 265-347, propose l'emploi d'une encre organique de type paraffine, laquelle se présente sous la forme d'une pâte à température ambiante. Cette pâte est alors liquéfiée (par chauffage) et aspirée vers l'extérieur.

Avec cette autre approche, le risque de desceller ou déformer le dispositif microstructuré est amoindri.

Cependant, cette autre approche reste limitée à un type particulier d'encre. Cela limite donc les types de dispositifs que l'on peut obtenir.

Par ailleurs, cette autre approche reste également limitée aux applications microfluidiques, dans la mesure où il reste nécessaire d'avoir des ouvertures pour évacuer le motif une fois liquéfié.

US2014/183044 et US 2005/151285 divulguent des procédés de fabrication d'un dispositif microstructuré sur un substrat en utilisant une couche d'encre solidifiée comme matériau sacrificiel qui est utilisé pour former la forme particulière d'une structure polymère déposée sur la couche d'encre.

Ainsi, un but de l'invention est de proposer un procédé de fabrication amélioré d'un dispositif microstructuré.

En particulier, un objectif de l'invention est de pouvoir élargir la gamme de matériaux envisageables pour réaliser le dispositif.

En particulier également, un autre objectif de l'invention est de pouvoir avoir accès à d'autres domaines que la microfluidique, dans lesquels le motif vise à former une cavité. Dans ce cas, il est en effet important de pouvoir évacuer le motif sans la présence d'ouvertures permettant cette évacuation.

A cet effet, l'invention propose un procédé de fabrication d'un dispositif microstructuré comprenant les étapes suivantes :
a) fournir un substrat ;
b) imprimer une encre, non solide, sur le substrat, l'encre se solidifiant au contact du substrat pour former un motif en négatif d'au moins une microstructure du dispositif microstructuré à fabriquer ;
c) envelopper l'encre sous forme solide avec un polymère non réticulé et comportant un additif apte à permettre une réticulation dudit polymère, ledit polymère étant non miscible avec le motif obtenu à l'étape b) afin de former une enveloppe pour le motif, ledit polymère présentant une température de fusion strictement supérieure à la température de sublimation ou d'évaporation de l'encre formant le motif ;
d) réticuler l'enveloppe ; puis
e) sublimer ou, selon la nature de l'encre, liquéfier puis évaporer l'encre de sorte à former le dispositif microstructuré comportant ladite au moins une microstructure.

Le procédé selon l'invention pourra comprendre également l'une au moins des caractéristiques suivantes, prises seules ou en combinaison :
- le substrat fourni à l'étape a) est un matériau hydrophobe choisi parmi : les polyimides (PI), les silicones dont le polydiméthylsiloxane (PDMS), le poplypropylène (PP), le polytétrafluoroéthylène (PTFE), le copolymère d'oléfine cyclique (COC) ou un matériau hydrophile choisi parmi le silicium, le verre, la cellulose, les fibres de verre ;
- entre l'étape a) et l'étape b), on réalise un traitement du substrat pour améliorer sa force d'adhésion avec l'encre à déposer et/ou le polymère destiné à former l'enveloppe ;
- au moins au cours de l'étape b), le substrat est refroidi à une température inférieure à la température de solidification de l'encre ;
- l'étape b) s'effectue sous une atmosphère présentant une humidité relative ne dépassant pas 30%, voire 15% ;
- au cours de l'étape b), l'impression s'effectue de sorte que chaque extrémité du motif en négatif de ladite au moins une microstructure du dispositif microstructuré à fabriquer se situe en bordure du substrat, de sorte que chaque extrémité puisse, sur le dispositif à fabriquer, former une ouverture, telle qu'une entrée ou une sortie de fluide, de sorte à former une microstructure se présentant sous la forme d'un canal ;
- entre l'étape b) et l'étape c), on réalise les sous-étapes suivantes : placer une connexion microfluidique, en partie au niveau de la région du motif qui est destinée à former une ouverture de canal et en partie à l'extérieur du substrat ; et appliquer de l'encre entre ladite connexion et le motif ;
- entre les étapes b) et c), on réalise un recuit, à une température avantageusement comprise entre 10% et 80% de la température de fusion du motif ;
- l'étape c) est réalisée en coulant le polymère sur le substrat imprimé par le motif ;
- le polymère introduit à l'étape c) est choisi parmi : le polydiméthylsiloxane (PDMS), les polyimides, les gels d'agarose ou une colle telle que l'acrylique ;
- l'additif présent dans le polymère est choisi parmi un agent réticulant, un photo-initiateur ou un solvant ;
- ledit polymère destiné à former l'enveloppe présente une température de fusion strictement supérieure à 110% de la température de sublimation ou d'évaporation de l'encre formant le motif ;
- l'étape e) s'effectue par chauffage et en appliquant un différentiel de pression entre l'intérieur de l'ensemble formé à l'issue de l'étape d) et l'extérieur ;
- la liquéfaction puis l'évaporation de l'encre à l'étape e) est réalisée par chauffage ;
- l'encre est choisie parmi :
   les glycols linéaires dont la formule brute générique est C₂ₙH₄ₙ₊₂O₂ où n est un nombre entier positif supérieur ou égal à 1, de préférence tel que n = 3, 4 ou 5 ;
   le cyclohexanediol ;
   le biphényl ;
   le tri(cyclohexyl)méthane ;
   les alcools de formule brute CₙH₂ₙ+₂O où n est un nombre entier positif supérieur ou égal à 1, de préférence tel que n = 10, 11 ou 12 ;
- au cours de l'étape b) on imprime plusieurs couches d'encre successives les unes sur les autres ;
- l'étape b) s'effectue par impression par jet d'encre, au moyen d'une buse d'impression et d'une encre liquide dont la viscosité est inférieure ou égale à 30 mPa.s⁻¹ ;
- la distance entre d'une part, ladite buse d'impression et d'autre part, le substrat est comprise entre 0,5mm et 20mm ; la taille d'une goutte d'encre éjectée par ladite buse d'impression est comprise entre 10µm et 100µm; la fréquence d'éjection des gouttes d'encre de ladite buse est comprise entre 50Hz et 5kHz ; le substrat d'une déplacement relatif de l'un par rapport à l'autre avec une vitesse de déplacement relative contrôlée, comprise entre 1mm/s et 100mm/s ;
- l'étape b) s'effectue au moyen d'une seringue contenant l'encre ;
- la distance entre d'une part, une extrémité de la seringue par laquelle l'encre est dispensée et d'autre part, le substrat est comprise entre 0,1mm et 1mm ; le débit d'encre dispensé par l'extrémité de ladite seringue est compris entre 0,01 nl/s et 10 nl/s ; le substrat d'une part et, ladite extrémité de seringue d'autre part, étant adaptés pour autoriser un déplacement relatif de l'un par rapport à l'autre avec une vitesse de déplacement relative contrôlée, comprise entre 0,1mm/s et 10mm/s.

L'invention sera mieux comprise et d'autres buts, avantages et caractéristiques de celle-ci apparaîtront plus clairement à la lecture de la description qui suit et qui est faite au regard des dessins annexés, sur lesquels :
- la figure 1 représente un premier dispositif apte à mettre en oeuvre le procédé selon l'invention ;
- la figure 2 représente un deuxième dispositif également apte à mettre en oeuvre le procédé selon l'invention ;
- la figure 3 représente l'évolution de l'épaisseur d'un dispositif microfluidique (canal), obtenu par la mise en oeuvre du procédé selon l'invention, en fonction d'un paramètre de fabrication de ce dispositif ;
- la figure 4 représente un dispositif microfluidique obtenu avec le procédé selon l'invention.

L'invention concerne un procédé de fabrication d'un dispositif microstructuré comprenant les étapes suivantes :
a) fournir un substrat ;
b) imprimer une encre, non solide, sur le substrat, l'encre se solidifiant au contact du substrat pour former un motif en négatif d'au moins une microstructure du dispositif microstructuré à fabriquer ;
c) envelopper l'encre sous forme solide avec un polymère non réticulé et comportant un additif apte à permettre une réticulation dudit polymère, ledit polymère étant non miscible avec le motif obtenu à l'étape b) afin de former une enveloppe pour le motif, ledit polymère présentant une température de fusion strictement supérieure à la température de sublimation ou d'évaporation de l'encre formant le motif ;
d) réticuler l'enveloppe ; puis
   polymère présentant une température de fusion strictement supérieure à la température de sublimation ou d'évaporation de l'encre formant le motif ;
d) réticuler l'enveloppe ; puis
e) sublimer ou, selon la nature de l'encre, liquéfier puis évaporer l'encre de sorte à former le dispositif microstructuré comportant ladite au moins une microstructure.

Dans le cadre de l'invention, une microstructure est une structure dont au moins deux dimensions sont inférieures à 1000 microns.

Ce procédé peut être mis en oeuvre de différentes façons.

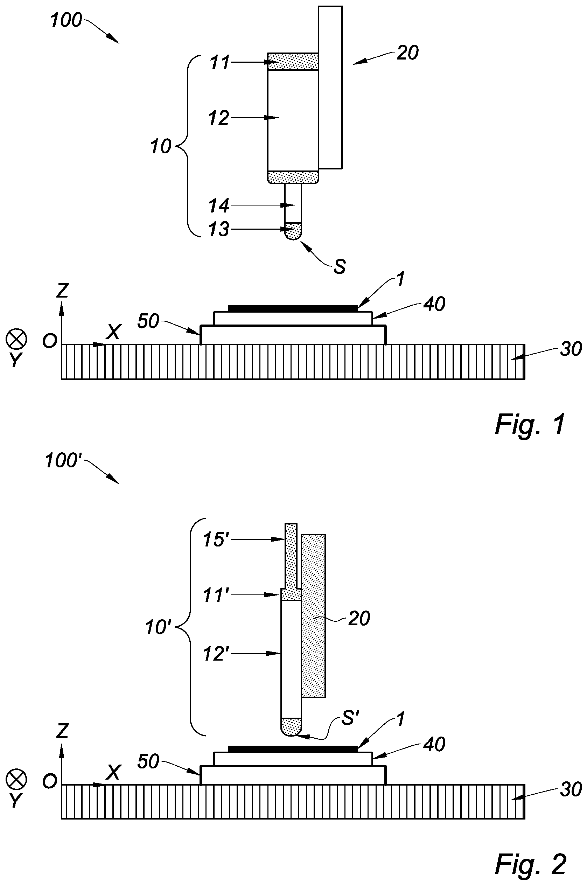

En particulier, on a représenté sur la figure 1 un premier dispositif 100 apte à mettre en oeuvre l'étape b).

Sur la figure 1, on a représenté un repère orthogonal direct (O, X, Y, Z).

Le dispositif 100 comprend un substrat 1 et un dispositif 10 d'impression par jet d'encre sur le substrat 1.

Le dispositif 10 d'impression par jet d'encre comporte un réservoir 11 dans lequel se situe de l'encre, un moyen de chauffage 12 pour l'encre située dans le réservoir 11, une buse d'impression 13 et un moyen de chauffage 14 pour l'encre située dans la buse d'impression 13.

Le dispositif 100 comprend également une première platine 20 montée sur le dispositif 10 d'impression par jet d'encre. Cette première platine permet le déplacement dudit dispositif 10 selon un axe prédéfini, en l'occurrence sur la figure 1, selon l'axe vertical OZ (axe vertical). On peut ainsi régler à souhait la distance, prise selon l'axe OZ, entre la sortie S de la buse d'impression 13 et le substrat 1.

Le dispositif 100 comprend aussi une deuxième platine 30 sur laquelle le substrat 1 est monté. Cette deuxième platine 30 permet le déplacement du substrat 1 dans le plan horizontal (O, X, Y). Ce plan horizontal est aussi le plan dans lequel le substrat 1 s'étend. Ceci permet de pouvoir donner la forme souhaitée à l'encre (motif déposé lors de l'étape b) sur le substrat 1. Il convient cependant de noter que le substrat 1 pourrait être incliné, c'est-à-dire présenter une orientation comportant une composante selon l'axe OZ (vertical), et notamment avec une inclinaison pouvant aller jusqu'à 45° par rapport à l'axe OX.

Entre le substrat 1 et la deuxième platine 30, le dispositif 100 peut comprendre un refroidisseur, fonctionnant par exemple par effet Peltier. Ce refroidisseur 40 peut être utile lorsque l'encre employée, chauffée au niveau du dispositif 10 d'impression par jet d'encre, a besoin d'être refroidi rapidement. Enfin, le dispositif 100 peut prévoir un moyen 50 d'évacuation de la chaleur entre le refroidisseur 40 et la deuxième platine 30.

Avantageusement, l'encre employée par cette technique d'impression par jet d'encre présente une viscosité inférieure ou égale à 30mPa.s⁻¹.

On a représenté sur la figure 2 un deuxième dispositif 100' également apte à mettre en oeuvre l'étape b).

La mise en oeuvre du procédé selon l'invention avec le deuxième dispositif 100' s'appuie sur l'emploi d'une seringue 10' contenant l'encre, en lieu et place du dispositif 10 d'impression par jet d'encre du premier dispositif 100. Ainsi, la seringue 10' comporte un réservoir 11' dans lequel se situe l'encre, un piston 15' pour pouvoir éjecter l'encre dudit réservoir 11' et un moyen de chauffage 12' pour chauffer l'encre présente dans le réservoir 11'. On notera que la sortie de la seringue 10' est dénommée S'.

Tout le reste est identique à ce qui a été décrit précédemment pour le premier dispositif 100 et en particulier, on notera que la première platine 20 est alors montée sur la seringue 10'.

Avec ce deuxième dispositif 100', on peut ainsi employer des encres dont la viscosité est plus élevée qu'avec le premier dispositif 100. En effet, avec une technique d'impression par jet d'encre (buse d'impression), on utilise une encre liquide dont la viscosité est généralement inférieure ou égale à 30 mPa.s⁻¹. Si des viscosités plus importantes peuvent être envisagées avec une technique d'impression par jet d'encre, l'utilisation d'une seringue permet assurément de lever une telle contrainte et d'avoir accès à des encres, qui bien que non solides, présentent une viscosité supérieure à 30mPa.s⁻¹.

Nous allons maintenant décrire différentes caractéristiques du procédé selon l'invention.

Le substrat fourni à l'étape a) pourra être un matériau hydrophobe, notamment choisi parmi : les polyimides (PI), les silicones dont le polydiméthylsiloxane (PDMS), le polypropylène (PP), le polytétrafluoroéthylène (PTFE) ou le copolymère d'oléfine cyclique (COC).

En variante, le substrat fourni à l'étape a) pourra être un matériau hydrophile, notamment choisi parmi le silicium, le verre, la cellulose, les fibres de verre.

Par ailleurs, l'encre pourra notamment être choisie parmi :
- les glycols linéaires dont la formule brute générique est C₂ₙH₄ₙ₊₂O₂ où n est un nombre entier positif supérieur ou égal à 1, de préférence tel que n = 3, 4 ou 5 ;
- le cyclohexanédiol ;
- le biphényl ;
- le tri(cyclohexyl)méthane ;
- les alcools de formule brute CₙH₂ₙ₊₂O où n est un nombre entier positif supérieur ou égal à 1, de préférence tel que n = 10, 11 ou 12.

En outre, le polymère destiné à former l'enveloppe pourra être choisi parmi le polydiméthylsiloxane (PDMS), les polyimides, les gels d'agarose ou certaines colles (acrylique, par exemple).

En particulier, on pourra prévoir l'association suivante (exemple 1 détaillé par la suite):
- substrat : polyimide
- encre (motif) :1,6-hexanediol (C₆H₁₄O₂), glycol linéaire avec n = 3 selon la formule brute générique rappelée précédemment
- polymère (enveloppe) : polydiméthylsiloxane (PDMS)

On pourra aussi prévoir l'association suivante (exemple 2 détaillé par la suite):
- substrat : verre
- encre (motif) :1,6-hexanediol
- polymère (enveloppe) : polydiméthylsiloxane (PDMS)

On notera que les deux exemples fournis ci-dessus, et détaillés par la suite, permettent de réaliser une microstructure se présentant sous la forme d'une cavité. En effet, l'encre 1,6-hexanediol peut passer à travers l'enveloppe en PDMS lorsque, cette encre est sublimée ou évaporée.

En particulier également, on pourra prévoir l'association suivante :
- substrat : polyimide
- encre (motif) : 1,6-hexanediol
- polymère (enveloppe) : acrylique

Encore une autre possibilité est de prévoir l'association suivante :
- substrat : gel d'agarose
- encre (motif) : biphényl
- polymère (enveloppe) : gel d'agarose

Il ne s'agit que d'exemples et d'autres associations sont envisageables.

Entre l'étape a) et l'étape b), on peut réaliser un traitement du substrat pour améliorer sa force d'adhésion avec l'encre à déposer et/ou le polymère destiné à former l'enveloppe. L'intérêt d'un tel traitement dépend principalement de la nature (type de matériau employé) du substrat. Ce traitement peut être choisi parmi un traitement plasma, en particulier à pression réduite et sous flux d'oxygène, un traitement par ultraviolets-ozone ou un traitement par oxydation par voie chimique.

D'un point de vue pratique, le procédé selon l'invention est tel que, au cours de l'étape b) et dans le cas de l'impression par jet d'encre :
- La distance entre d'une part, ladite buse d'impression et d'autre part, le substrat est comprise entre 0,5mm et 20mm ;
- La taille d'une goutte d'encre éjectée par ladite buse d'impression est comprise entre 10µm et 100µm ;
- La fréquence d'éjection des gouttes d'encre de ladite buse est comprise entre 50Hz et 5kHz ;
- Le substrat d'une part et ladite buse d'impression d'autre part, étant adaptés pour autoriser un déplacement relatif de l'un par rapport à l'autre avec une vitesse de déplacement relative contrôlée, comprise entre 1mm/s et 100mm/s.

Les quatre paramètres mentionnés ci-dessus (taille de goutte, distance extrémité de buse au substrat, fréquence d'éjection des gouttes et vitesse de déplacement relatif entre buse et substrat) contribuent à la définition de la géométrie du motif déposé sur le substrat.

Ainsi, si la distance entre d'une part, ladite buse d'impression par laquelle l'encre est éjectée et d'autre part, le substrat est trop petite, on perd en résolution. Si cette même distance est trop grande, la goutte d'encre risque d'être perturbée dans sa descente vers le substrat. Il est donc plus avantageux de travailler dans la gamme de distance mentionnée ci-dessus.

La fréquence d'éjection des gouttes et la vitesse de déplacement relative mentionnées ci-dessus permettent de gérer la distance séparant deux gouttes déposées successivement sur le substrat. D'un point de vue très pratique, il convient en effet que les gouttes ne soient pas trop distantes l'une de l'autre si l'on veut obtenir une microstructure de taille contrôlée (c'est en particulier le cas pour une application microfluidique pour laquelle on cherche à définir un canal). A contrario, il convient également que les gouttes ne soient pas trop proches pour gérer correctement l'épaisseur du motif.

La taille d'une goutte permet de gérer la quantité d'encre déposée localement sur le substrat, ce qui a notamment une influence sur la largeur et l'épaisseur du motif.

D'un point de vue pratique également, le procédé selon l'invention est tel que, au cours de l'étape b) et dans le cas de l'impression avec une seringue :
- La distance entre d'une part, une extrémité de la seringue par laquelle l'encre est dispensée et d'autre part, le substrat est comprise entre 0,1mm et 1mm ;
- Le débit d'encre dispensé par l'extrémité de ladite seringue est compris entre 0,01 nl/s (nanolitre par seconde) et 10 nl/s ;
- Le substrat d'une part et, ladite extrémité de seringue d'autre part, étant adaptés pour autoriser un déplacement relatif de l'un par rapport à l'autre avec une vitesse de déplacement relative contrôlée, comprise entre 0,1mm/s et 10mm/s.

Les trois paramètres mentionnés ci-dessus (volume dispensé, distance extrémité de seringue au substrat et vitesse de déplacement relatif entre la seringue et le substrat) contribuent à la définition de la géométrie du motif déposé sur le substrat.

Ainsi, si la distance entre d'une part, l'extrémité de la seringue par laquelle l'encre est dispensée et d'autre part, le substrat est trop faible, on perd en résolution. Si cette même distance est trop grande, la colonne de liquide se déstabilise. On pourrait parfaitement ne pas fonctionner dans la gamme susmentionnée, mais ce choix est plus avantageux car cela facilite la mise en oeuvre.

Le débit d'encre dispensée et la vitesse de déplacement relative mentionnée ci-dessus permettent de gérer la quantité d'encre déposée localement sur le substrat, ce qui a notamment une influence sur la largeur et l'épaisseur du motif.

Par ailleurs, au moins au cours de l'étape b), le substrat peut être refroidi à une température inférieure à la température de solidification de l'encre. Pour certaines encres dont la température d'impression (non solide) est relativement importante par rapport à la température de solidification, cela permet d'accélérer la solidification de l'encre sur le substrat. Ceci permet, pour certaines encres, d'améliorer le contrôle de la géométrie du motif déposé à l'étape b). En effet, si les conditions d'éjection ou de dépôt permettent souvent le contrôle complet de la géométrie du motif déposé sur le substrat, il s'avère que, pour certaines encres, ce refroidissement évite un étalement trop important de la goutte sur le substrat avant sa solidification. Cela permet de conserver la géométrie du motif souhaitée avec les conditions d'éjection ou de dépôt mentionnées précédemment. Une autre conséquence est que cela permet d'accélérer la fabrication du dispositif microstructuré.

On notera que le refroidissement du substrat peut être géré par une cellule à effet Peltier.

L'étape b) peut s'effectuer sous vide (vide poussé) ou sous atmosphère neutre, par exemple sous air. Lorsque cette étape s'effectue sous atmosphère neutre, en particulier sous air, on peut notamment envisager de fonctionner à pression atmosphérique. Travailler sous air à pression atmosphérique facilite en effet la mise en oeuvre. Typiquement, on peut envisager de mettre en oeuvre l'étape b) dans une gamme de pression comprise entre 10⁻⁴ Pa et 1,013.10⁵ Pa.

Lorsque l'on n'est pas sous vide, différents types d'atmosphère peuvent être envisagés, notamment à l'air ambient. Dans ce dernier cas, il peut être avantageux, tout particulièrement lorsqu'une encre hydrophile est employée, de faire en sorte que le taux d'humidité relative ne dépasse pas, au moins au cours de cette étape b), 30%, voire 15%. Cela permet d'éviter que l'encre, dans son parcours entre la buse ou, selon le cas, l'extrémité de la seringue d'une part et le substrat d'autre part, n'absorbe de l'humidité ; ce qui peut avoir un impact sur la résolution du dépôt du motif sur le substrat. Cela permet aussi d'éviter la condensation éventuelle d'eau sur le substrat (que celui-ci soit hydrophile ou hydrophobe), laquelle est alors également favorisée par le refroidissement du substrat, avec pour conséquence néfaste éventuelle un mauvais contrôle de la forme et de la résolution du motif.

L'étape c) peut s'effectuer en coulant le polymère sur le substrat imprimé par le motif. Le polymère, destiné à former l'enveloppe, est alors déposé sous forme liquide. Par ailleurs, il convient de noter que le polymère choisi pour former l'enveloppe est non miscible avec l'encre (motif). Dans le cas contraire, il ne serait pas envisageable d'obtenir le dispositif microstructuré, à savoir de définir tout simplement une cavité ou un canal.

Il convient de noter que le polymère comprend un additif apte à permettre la réticulation du polymère destiné à former l'enveloppe, lors de l'étape d) ultérieure. D'un point de vue pratique, le mélange polymère/additif est préparé en amont si bien qu'on coule (verse) un polymère comportant cet additif.

L'étape d) (réticulation de l'enveloppe) s'appuie donc sur la présence de cet additif.

Cet additif peut être un agent réticulant tel que le méthylhydrosiloxane, un photo-initiateur tel que le 1-Hydroxy-cyclohexyl-phenyl-kétone ou un solvant tel que le formaldéhyde.

Dans le cas où l'additif est un agent réticulant, et en fonction de la nature de ce réticulant et/ou du polymère, la réticulation peut s'effectuer à température ambiante, éventuellement aidé par un faible chauffage pour accélérer la réticulation. Toujours lorsque l'additif est un agent réticulant, et si la nature du réticulant et/ou celle du polymère n'autorise pas une réticulation à température ambiante, la réticulation peut s'effectuer par chauffage.

Dans le cas où l'additif est un photo-initiateur, la réticulation peut s'effectuer en soumettant le polymère à un rayonnement ultraviolet. Un photo-initiateur peut notamment être envisagé avec certaines colles, qui deviennent alors réticulables par ultraviolets.

Enfin, dans le cas où l'additif est un solvant, la réticulation s'effectue par simple évaporation du solvant, qui s'effectue généralement à température ambiante. Une fois l'évaporation du solvant effectué, le polymère réticule.

A l'étape d), le motif en négatif (encre) est sous forme solide.

Ainsi, lorsque l'additif présent dans le polymère non réticulé est un agent de réticulation, et qu'il convient de chauffer le polymère pour assurer sa réticulation, il convient que la température de réticulation du polymère soit inférieure à la température de fusion de l'encre, même si la réticulation peut prévoir, afin de finaliser la réticulation, un bref passage à une température supérieure à la température de fusion du motif. Dans ce dernier cas, une petite partie du motif peut se liquéfier, mais comme le polymère est en grande majorité déjà réticulé, cela n'implique alors pas de modification de l'interface entre le motif et l'enveloppe. En particulier, dans bien des cas, on peut envisager une réticulation à température ambiante, pendant 24h, suivi d'une finalisation de la réticulation à température plus élevée, en particulier au-dessus de la température de fusion du motif, sans pour autant faire passer ce motif à l'état gazeux, pendant quelques dizaines de minutes, voire une heure.

Avantageusement, on pourra prévoir que le polymère formant l'enveloppe présente une température de réticulation inférieure ou égale à 90% de la température de fusion de l'encre (motif).

En fonction de l'encre employée, on peut soit sublimer le motif, soit le liquéfier puis l'évaporer.

Ainsi, pour sublimer le motif l'étape e) s'effectue par chauffage et en appliquant un différentiel de pression entre l'intérieur de l'ensemble formé à l'issue de l'étape d) et l'extérieur. Ceci permet de se placer, dans le diagramme de phase de l'encre (motif), sur un couple pression, température permettant directement le passage de l'état solide à l'état vapeur. Lorsque cela est envisageable, c'est particulièrement avantageux car on limite le niveau de chauffage de l'ensemble formé à l'étape d), et donc l'énergie dépensée, pour mettre le motif sous forme de vapeur et donc l'éliminer afin de former la microstructure (cavité, canal, ...).

En variante, ou à défaut, lorsqu'il n'est pas raisonnablement possible de prévoir une sublimation de l'encre (motif), l'étape e) est réalisée par chauffage afin d'assurer la liquéfaction, puis la vaporisation de l'encre (motif).

Dans les deux cas, mettre l'encre (motif) sous forme vapeur est particulièrement avantageux dans la mesure où l'extraction des vapeurs est très aisé.

On comprend aussi pourquoi il est important de choisir un polymère pour l'enveloppe avec certaines propriétés physiques. En effet, lors du chauffage visant à faire disparaître l'encre (motif) pour définir ladite au moins une microstructure, l'enveloppe doit rester sous forme solide. Et c'est donc pour cette raison que le polymère choisi pour l'enveloppe doit présenter une température de fusion (passage de l'état solide vers l'état liquide) strictement supérieure à la température de sublimation de l'encre (motif), ou selon le cas, supérieure à la température d'évaporation de l'encre (motif).

On s'assure ainsi que l'enveloppe reste en place lors de la mise en oeuvre de l'étape e).

Avantageusement, on pourra prévoir que le polymère formant l'enveloppe présente une température de fusion strictement supérieure ou égale à 110% de la température de sublimation ou, selon le cas de la température d'évaporation de l'encre formant le motif. Cela revient à dire que l'encre formant le motif présente une température de sublimation ou, selon le cas une température d'évaporation, sensiblement inférieure ou égale à 90% de la température de fusion de l'enveloppe.

Il peut être intéressant d'effectuer, entre les étapes b) et c) un recuit. Un tel recuit permet de diminuer la rugosité du motif déposé à l'étape b). En effet, une fois le motif solidifié et malgré le soin apporté aux conditions de dépôt, on peut constater que le motif, sous forme solide, présente une rugosité non négligeable. En conséquence, cette rugosité pourra se retrouver sur la microstructure à former (négatif). En particulier, pour les applications microfluidiques, la rugosité peut changer les conditions d'écoulement dans la microstructure (canal) et par suite, les pertes de charges et/ou les échanges thermiques. Pour d'autres applications, par exemple en optique, on comprend que cette rugosité au sein de la microstructure (cavité) peut également modifier les conditions d'analyse.

On comprend qu'un tel recuit, comme tout recuit, s'effectuera à une température strictement inférieure à la température de fusion du motif (encre) déposé à l'étape b) sur le substrat et typiquement dans une gamme de valeurs comprise entre 10% et 80% de la température de fusion du motif (encre, sous forme solide).

Avec le procédé selon l'invention, il est possible de réaliser un dispositif comprenant une microstructure, fermée (cavité) ou ouverte (canal) entre le substrat et l'enveloppe.

Une cavité peut présenter un intérêt pour certaines applications, par exemple en optique ou en acoustique.

Toutefois, dans le cadre de l'invention, le procédé sera tout particulièrement pour fabriquer un dispositif microfluidique, dans lequel la microstructure est un canal (comprenant donc des ouvertures, telle qu'une entrée et une sortie pour un fluide).

Dans le cas où la microstructure est un canal, l'impression réalisée au cours de l'étape b), s'effectue de sorte que chaque extrémité du motif en négatif dudit au moins un canal du dispositif microfluidique à fabriquer se situe en bordure du substrat, de sorte que chaque extrémité puisse, sur le dispositif à fabriquer, former une ouverture de canal, telle qu'une entrée ou une sortie de fluide.

Afin de faciliter la connexion du dispositif microfluidique fabriqué avec le procédé selon l'invention à tout système externe, on peut en outre prévoir de placer une connexion microfluidique, en partie au niveau de la région du motif qui est destinée à former une ouverture de canal et en partie à l'extérieur du substrat ; puis d'appliquer de l'encre entre ladite connexion et le motif.

La connexion ainsi formée, qui fait partie intégrante du dispositif microfluidique fabriqué, dépasse alors en partie du substrat (et donc de l'enveloppe). Ceci facilite donc grandement la connexion fluidique à un système externe.

Nous allons maintenant décrire quelques exemples de réalisation d'un dispositif microfluidique avec un procédé conforme à l'invention.

### Exemple 1

Substrat : un substrat en polyimide a été fourni (étape a)), en l'occurrence un Kapton^{®} HN proposé par la société DuPont de Nemours.

Dans le cas d'espèce, le Kapton^{®} HN utilisé est stable aux températures employées dans cet exemple.

Motif (encre) : le 1,6-hexanediol (C₆H₁₄O₂) a été choisi comme encre.

Cette encre présente les propriétés suivantes : T_{fusion} = 45°C (air, pression atmosphérique) et Tᵥₐₚₒᵣᵢₛₐₜᵢₒₙ = 250°C (air, pression atmosphérique).

Pour mettre en oeuvre l'étape b), cette encre a été chauffée à 65°C (donc, sous forme liquide) pour réaliser l'impression sur le substrat, selon la technique d'impression par jet d'encre (cette température permet notamment de s'assurer que la viscosité dynamique de l'encre liquide est inférieure à 30 mPa.s).

La buse d'impression a été positionnée à 5mm du substrat.

Chaque goutte d'encre éjectée de la buse d'impression présentait un diamètre de 60µm. Les gouttes ont été éjectées de la buse d'impression à une fréquence de 100Hz.

La vitesse relative entre la buse d'impression et le substrat était de 4mm/s.

L'impression s'est effectuée de sorte que chaque extrémité du motif en négatif de la microstructure à fabriquer se situe en bordure du substrat, de sorte que chaque extrémité puisse, sur le dispositif à fabriquer, former une ouverture de canal (une entrée et une sortie de fluide).

Par ailleurs, lors de l'impression, le substrat a été refroidi à -10°C (avec une cellule à effet Peltier) pour assurer la solidification plus rapide de l'encre.

Enveloppe (polymère) :
Le polymère employé est du polydiméthylsiloxane (PDMS), en l'occurrence le Sylgard^{®} 184.

Ce polymère a été mélangé avec un agent réticulant, en l'occurrence le méthylhydrosiloxane, dans un rapport massique de 1/10 (1 pour l'agent réticulant et 10 pour le polymère).

Le polymère ainsi préparé a été coulé, à température ambiante, sur le substrat imprimé par le motif, pour mettre en oeuvre l'étape c).

Ensuite, l'étape d) de réticulation a été mise en oeuvre : réticulation pendant 24h à température ambiante.

Une fois réticulé, le PDMS mentionné ci-dessus est stable sur la plage de température comprise entre -45°C et 200°C.

L'étape e) a ensuite été effectuée.

A cet effet, l'ensemble obtenu à l'issue de l'étape d) a été chauffée à une température de 100°C et sous une pression de 0.1bar.

Dans ces conditions, le motif s'est sublimé.

### Exemple 2

Dans ce deuxième exemple, le substrat en Kapton^{®} (Exemple 1) est remplacé par un substrat en verre.

L'étape d'impression a été réalisée sous air, avec une humidité relative inférieure à 15%. En effet, le verre présente un caractère hydrophile alors que le Kapton^{®} employé comme substrat dans l'exemple 1 présente un caractère hydrophobe.

Tout le reste est identique au premier exemple.

Fin de l'exemple 2.

Il convient de noter enfin qu'à l'issue du procédé de fabrication, on obtient un dispositif comportant une enveloppe sur un substrat. Comme cela a été indiqué précédemment, en fonction de la nature (matériau) de l'enveloppe et/ou de la nature (matériau) du substrat (matériau), il peut arriver que la cohésion entre l'enveloppe et le substrat soit relativement faible. Si l'on souhaite faire en sorte que le polymère tienne sur le substrat, on peut prévoir l'étape de traitement (plasma, etc...) du substrat mentionnée précédemment.

Toutefois, on peut aussi mettre à profit ce manque de cohésion entre le substrat et l'enveloppe pour ne récupérer que l'enveloppe. Cette enveloppe peut alors servir de moule pour d'autres utilisations.

### Exemple 3

Dans ce troisième exemple, le substrat est en verre.

L'étape d'impression a été réalisée sous air, avec une humidité relative inférieure à 15%.

Le reste est identique à l'exemple 1, à l'exception du fait que l'étape d'impression (étape b)) pour laquelle on imprime plusieurs couches d'encre successives les unes sur les autres.

D'un point de vue pratique, ceci s'effectue en effectuant un ou plusieurs passages supplémentaires de la buse d'impression, au-dessus de la première couche d'encre déposée au premier passage, les conditions de dépôt du ou de chaque passage supplémentaire étant identique aux conditions de dépôt du premier passage.

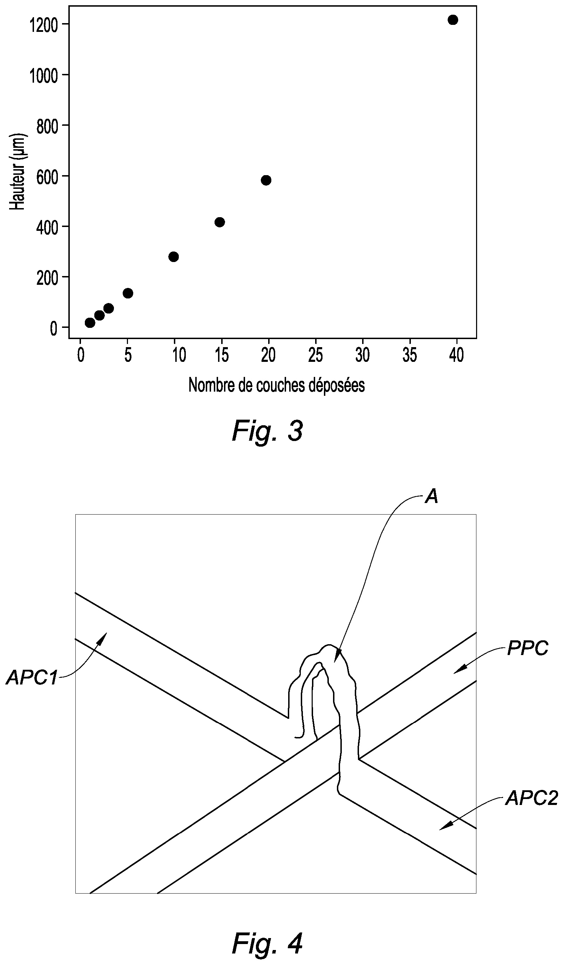

La figure 3 représente l'évolution de la hauteur du canal ainsi obtenu en fonction du nombre de couches d'encre successivement déposées au cours de l'étape b). On note que cette relation est linéaire. Ceci es lié au fait que les conditions de dépôt de l'encre sont identiques d'une couche à l'autre.

Au final, ceci permet donc de définir un canal dont la section présente un rapport de forme élevé ( = rapport hauteur/largeur).

### Exemple 4

Dans ce quatrième exemple, le substrat est en verre.

L'étape d'impression a été réalisée sous air, avec une humidité relative inférieure à 15%.

Le reste est identique à l'exemple 1, à l'exception du fait que l'étape d'impression (étape b)) est réalisée de manière spécifique pour pouvoir fabriquer des canaux qui se croisent.

Ainsi, après avoir déposé de l'encre, conformément à l'exemple 1, afin de former une première partie de canal PPC et déposé de l'encre pour former d'autres parties de canal APC1, APC2 de part et d'autre de la première partie de canal, ces autres parties de canal étant destinées à croiser la première partie de canal, il convient de réaliser une arche permettant de relier les parties de canal APC1, APC2 en passant par-dessus la première partie de canal PPC.

A cet effet, certaines conditions de dépôt de l'étape b) d'impression ont été modifiées. En l'occurrence :
- Les gouttes d'encre ont été éjectées à une fréquence de 4Hz ;
- La vitesse relative entre la buse d'impression et le substrat était de 0,12 mm/s.

La figure 4 montre l'arche A ainsi formée, faisant partie intégrante du canal.

## Revendications

1. Procédé de fabrication d'un dispositif microstructuré comprenant les étapes suivantes :
a) fournir un substrat ;
b) imprimer une encre, non solide, sur le substrat, l'encre se solidifiant au contact du substrat pour former un motif en négatif d'au moins une microstructure du dispositif microstructuré à fabriquer ;
c) envelopper l'encre sous forme solide avec un polymère non réticulé et comportant un additif apte à permettre une réticulation dudit polymère, ledit polymère étant non miscible avec le motif obtenu à l'étape b) afin de former une enveloppe pour le motif, ledit polymère présentant une température de fusion strictement supérieure à la température de sublimation ou d'évaporation de l'encre formant le motif ;
d) réticuler l'enveloppe ; puis
e) sublimer ou, selon la nature de l'encre, liquéfier puis évaporer l'encre de sorte à former le dispositif microstructuré comportant ladite au moins une microstructure.

2. Procédé selon la revendication 1, dans lequel le substrat fourni à l'étape a) est un matériau hydrophobe choisi parmi : les polyimides (PI), les silicones dont le polydiméthylsiloxane (PDMS), le poplypropylène (PP), le polytétrafluoroéthylène (PTFE), le copolymère d'oléfine cyclique (COC) ou un matériau hydrophile choisi parmi le silicium, le verre, la cellulose, les fibres de verre.

3. Procédé selon l'une des revendications précédentes, dans lequel, entre l'étape a) et l'étape b), on réalise un traitement du substrat pour améliorer sa force d'adhésion avec l'encre à déposer et/ou le polymère destiné à former l'enveloppe.

4. Procédé selon l'une des revendications précédentes, dans lequel, au moins au cours de l'étape b), le substrat est refroidi à une température inférieure à la température de solidification de l'encre.

5. Procédé selon l'une des revendications précédentes, dans lequel l'étape b) s'effectue sous une atmosphère présentant une humidité relative ne dépassant pas 30%, voire 15%.

6. Procédé selon l'une des revendications précédentes, dans lequel, au cours de l'étape b), l'impression s'effectue de sorte que chaque extrémité du motif en négatif de ladite au moins une microstructure du dispositif microstructuré à fabriquer se situe en bordure du substrat, de sorte que chaque extrémité puisse, sur le dispositif à fabriquer, former une ouverture, telle qu'une entrée ou une sortie de fluide, de sorte à former une microstructure se présentant sous la forme d'un canal.

7. Procédé selon la revendication précédente, dans lequel, entre l'étape b) et l'étape c), on réalise les sous-étapes suivantes :
- placer une connexion microfluidique, en partie au niveau de la région du motif qui est destinée à former une ouverture de canal et en partie à l'extérieur du substrat ; et
- appliquer de l'encre entre ladite connexion et le motif.

8. Procédé selon l'une des revendications précédentes, dans lequel, entre les étapes b) et c), on réalise un recuit, à une température avantageusement comprise entre 10% et 80% de la température de fusion du motif.

9. Procédé selon l'une des revendications précédentes, dans lequel l'étape c) est réalisée en coulant le polymère sur le substrat imprimé par le motif.

10. Procédé selon l'une des revendications précédentes, dans lequel le polymère introduit à l'étape c) est choisi parmi : le polydiméthylsiloxane (PDMS), les polyimides, les gels d'agarose ou ne colle telle que l'acrylique.

11. Procédé selon l'une des revendications précédentes, dans lequel l'additif présent dans le polymère est choisi parmi un agent réticulant, un photo-initiateur ou un solvant.

12. Procédé selon l'une des revendications précédentes, dans lequel ledit polymère destiné à former l'enveloppe présente une température de fusion strictement supérieure à 110% de la température de sublimation ou d'évaporation de l'encre formant le motif.

13. Procédé selon l'une des revendications précédentes, dans lequel la sublimation de l'étape e) s'effectue par chauffage et en appliquant un différentiel de pression entre l'intérieur de l'ensemble formé à l'issue de l'étape d) et l'extérieur.

14. Procédé selon l'une des revendications 1 à 16 dans lequel la liquéfaction puis l'évaporation de l'encre à l'étape e) est réalisée par chauffage.

15. Procédé selon l'une des revendications précédentes, dans lequel l'encre est choisie parmi :
- les glycols linéaires dont la formule brute générique est C₂ₙH₄ₙ+₂O₂ où n est un nombre entier positif supérieur ou égal à 1, de préférence tel que n = 3, 4 ou 5 ;
- le cyclohexanediol ;
- le biphényl ;
- le tri(cyclohexyl)méthane ;
- les alcools de formule brute CₙH₂ₙ+₂O où n est un nombre entier positif supérieur ou égal à 1, de préférence tel que n = 10, 11 ou 12.

16. Procédé selon l'une des revendications précédentes, dans lequel au cours de l'étape b) on imprime plusieurs couches d'encre successives les unes sur les autres.

17. Procédé selon l'une des revendications précédentes, dans lequel l'étape b) s'effectue par impression par jet d'encre, au moyen d'une buse d'impression et d'une encre liquide dont la viscosité est inférieure ou égale à 30 mPa.s⁻¹.

18. Procédé selon la revendication précédente, dans lequel :
- la distance entre d'une part, ladite buse d'impression et d'autre part, le substrat est comprise entre 0,5mm et 20mm ;
- la taille d'une goutte d'encre éjectée par ladite buse d'impression est comprise entre 10µm et 100µm ;
- la fréquence d'éjection des gouttes d'encre de ladite buse est comprise entre 50Hz et 5kHz ;
- le substrat d'une part et ladite buse d'impression d'autre part, étant adaptés pour autoriser un déplacement relatif de l'un par rapport à l'autre avec une vitesse de déplacement relative contrôlée, comprise entre 1mm/s et 100mm/s.

19. Procédé selon l'une des revendications 1 à 16, dans lequel l'étape b) s'effectue au moyen d'une seringue contenant l'encre.

20. Procédé selon la revendication précédente, dans lequel :
- la distance entre d'une part, une extrémité de la seringue par laquelle l'encre est dispensée et d'autre part, le substrat est comprise entre 0,1mm et 1mm ;
- le débit d'encre dispensé par l'extrémité de ladite seringue est compris entre 0,01 nl/s et 10 nl/s ;
- le substrat d'une part et, ladite extrémité de seringue d'autre part, étant adaptés pour autoriser un déplacement relatif de l'un par rapport à l'autre avec une vitesse de déplacement relative contrôlée, comprise entre 0,1mm/s et 10mm/s.

## Patentansprüche

1. Verfahren zur Herstellung einer mikrostrukturierten Vorrichtung, umfassend die folgenden Schritte:
a) Bereitstellen eines Substrats;
b) Drucken einer nicht festen Tinte auf das Substrat, wobei die Tinte bei Kontakt des Substrats erstarrt, um ein Negativmuster von mindestens einer Mikrostruktur der herzustellenden mikrostrukturierten Vorrichtung zu bilden;
c) Umhüllen der Tinte in fester Form mit einem nicht vernetzten Polymer, das ein Additiv aufweist, das in der Lage ist, eine Vernetzung des Polymers zu ermöglichen, wobei das Polymer mit dem in Schritt b) erhaltenen Muster nicht mischbar ist, um eine Hülle für das Muster zu bilden, wobei das Polymer eine Schmelztemperatur aufweist, die strikt über der Sublimations- oder Verdampfungstemperatur der das Muster bildenden Tinte liegt;
d) Vernetzen der Hülle; dann
e) Sublimieren oder, je nach Art der Tinte, Verflüssigen und dann Verdampfen der Tinte, sodass die mikrostrukturierte Vorrichtung gebildet wird, welche die mindestens eine Mikrostruktur aufweist.

2. Verfahren nach Anspruch 1, wobei das in Schritt a) bereitgestellte Substrat ein hydrophobes Material ist, ausgewählt aus: Polyimiden (PI), Silikonen einschließlich Polydimethylsiloxan (PDMS), Polypropylen (PP), Polytetrafluorethylen (PTFE), zyklischem Olefincopolymer (COC) oder einem hydrophilen Material, ausgewählt aus Silizium, Glas, Zellulose, Glasfasern.

3. Verfahren nach einem der vorstehenden Ansprüche, wobei zwischen Schritt a) und Schritt b) eine Behandlung des Substrats durchgeführt wird, um seine Haftkraft mit der aufzubringenden Tinte und/oder dem zur Bildung der Hülle bestimmten Polymer zu verbessern.

4. Verfahren nach einem der vorstehenden Ansprüche, wobei zumindest im Laufe des Schritts b) das Substrat auf eine Temperatur unterhalb der Erstarrungstemperatur der Tinte abgekühlt wird.

5. Verfahren nach einem der vorstehenden Ansprüche, wobei Schritt b) in einer Atmosphäre, die eine relative Luftfeuchtigkeit von nicht mehr als 30% oder sogar 15% aufweist, durchgeführt wird.

6. Verfahren nach einem der vorstehenden Ansprüche, wobei im Laufe des Schritts b) der Druck derart erfolgt, dass sich jedes Ende des Negativmusters der mindestens einen Mikrostruktur der herzustellenden mikrostrukturierten Vorrichtung am Rand des Substrats befindet, sodass jedes Ende auf der herzustellenden Vorrichtung eine Öffnung, wie einen Fluideinlass oder -auslass, bilden kann, um so eine Mikrostruktur in Form eines Kanals zu bilden.

7. Verfahren nach dem vorstehenden Anspruch, wobei zwischen Schritt b) und Schritt c) die folgenden Unterschritte durchgeführt werden:
- Platzieren einer mikrofluidischen Verbindung, teilweise im Bereich der Musterregion, die dazu bestimmt ist, eine Kanalöffnung zu bilden, und teilweise außerhalb des Substrats; und
- Aufbringen von Tinte zwischen der Verbindung und dem Muster.

8. Verfahren nach einem der vorstehenden Ansprüche, wobei zwischen den Schritten b) und c) eine Glühung durchgeführt wird, bei einer Temperatur, die vorteilhafterweise zwischen 10% und 80% der Schmelztemperatur des Musters liegt.

9. Verfahren nach einem der vorstehenden Ansprüche, wobei Schritt c) durch Gießen des Polymers auf das mit dem Muster bedruckte Substrat durchgeführt wird.

10. Verfahren nach einem der vorstehenden Ansprüche, wobei das in Schritt c) eingeführte Polymer ausgewählt ist aus: Polydimethylsiloxan (PDMS), Polyimiden, Agarose- oder Klebstoffgelen wie Acryl.

11. Verfahren nach einem der vorstehenden Ansprüche, wobei das in dem Polymer vorhandene Additiv aus einem Vernetzungsmittel, einem Photoinitiator oder einem Lösungsmittel ausgewählt ist.

12. Verfahren nach einem der vorstehenden Ansprüche, wobei das Polymer zur Bildung der Hülle eine Schmelztemperatur aufweist, die strikt über 110% der Sublimations- oder Verdampfungstemperatur der das Muster bildenden Tinte liegt.

13. Verfahren nach einem der vorstehenden Ansprüche, wobei die Sublimation in Schritt e) durch Erhitzen und durch Anlegen einer Druckdifferenz zwischen dem Inneren der im Anschluss an Schritt d) gebildeten Einheit und dem Äußeren erfolgt.

14. Verfahren nach einem der Ansprüche 1 bis 16, wobei die Verflüssigung und anschließende Verdampfung der Tinte in Schritt e) durch Erhitzen erfolgt.

15. Verfahren nach einem der vorstehenden Ansprüche, wobei die Tinte ausgewählt ist aus:
- linearen Glykolen, deren generische Summenformel C2nH4n+2O2 lautet, wobei n eine positive ganze Zahl größer oder gleich 1 ist, vorzugsweise derart, dass n = 3, 4 oder 5 ist;
- Cyclohexandiol;
- Biphenyl;
- Tri(cyclohexyl)methan;
- Alkoholen der Summenformel CnH2n+2O, wobei n eine positive ganze Zahl größer oder gleich 1 ist, vorzugsweise derart, dass n = 10, 11 oder 12 ist.

16. Verfahren nach einem der vorstehenden Ansprüche, wobei im Laufe des Schritts b) mehrere aufeinanderfolgende Tintenschichten übereinander gedruckt werden.

17. Verfahren nach einem der vorstehenden Ansprüche, wobei Schritt b) durch Tintenstrahldruck mittels einer Druckdüse und einer flüssigen Tinte, die eine Viskosität von weniger als oder gleich 30mPa.s-1 aufweist, durchgeführt wird.

18. Verfahren nach dem vorstehenden Anspruch, wobei:
- der Abstand zwischen einerseits der Druckdüse und andererseits dem Substrat zwischen 0,5mm und 20mm liegt;
- die Größe eines Tintentropfens, der von der Druckdüse ausgestoßen wird, zwischen 10µm und 100µm liegt;
- die Frequenz des Ausstoßes der Tintentropfen aus der Düse zwischen 50Hz und 5kHz liegt;
- wobei das Substrat einerseits und die Druckdüse andererseits dazu ausgelegt sind, eine relative Verschiebung des einen relativ zum anderen mit einer kontrollierten relativen Verschiebungsgeschwindigkeit zwischen 1mm/s und 100mm/s zu ermöglichen.

19. Verfahren nach einem der Ansprüche 1 bis 16, wobei Schritt b) mittels einer Spritze, welche die Tinte enthält, durchgeführt wird.

20. Verfahren nach dem vorstehenden Anspruch, wobei:
- der Abstand zwischen einem Ende der Spritze, durch das die Tinte abgegeben wird, und dem Substrat zwischen 0,1mm und 1mm liegt;
- der aus dem Ende der Spritze abgegebene Tintendurchfluss zwischen 0,01nl/s und 10nl/s beträgt;
- wobei das Substrat einerseits und das Spritzenende andererseits dazu ausgelegt sind, eine relative Verschiebung des einen relativ zum anderen mit einer kontrollierten relativen Verschiebungsgeschwindigkeit zwischen 0,1mm/s und 10mm/s zu ermöglichen.

## Claims

1. A method for manufacturing a microstructured device comprising the following steps:
a) providing a substrate
b) printing a non-solid ink on the substrate, the ink solidifying upon contact with the substrate to form a negative pattern of at least one microstructure of the microstructured device to be fabricated;
c) covering the ink in solid form with a non-crosslinked polymer comprising an additive capable of allowing crosslinking of said polymer, said polymer being immiscible with the pattern obtained in step b) in order to form a cover for the pattern, said polymer having a melting temperature strictly higher than the sublimation or evaporation temperature of the ink forming the pattern;
d) cross-linking the cover; then
e) sublimating or, depending on the nature of the ink, liquefying and then evaporating the ink so as to form the microstructured device comprising said at least one microstructure.

2. The method according to claim 1, wherein the substrate provided in step a) is a hydrophobic material selected from: polyimides (P!), silicones including polydimethylsiloxane (PDMS), polypropylene (PP), polytetrafluoroethylene (PTFE), cyclic olefin copolymer (COC), or a hydrophilic material selected from silicon, glass, cellulose, glass fibres.

3. The method according to one of the preceding claims, wherein between step a) and step b), a treatment of the substrate is performed to improve its adhesion strength with the ink to be deposited and/or the polymer intended to form the cover.

4. The method according to one of the preceding claims, wherein, at least during step b), the substrate is cooled to a temperature below the solidification temperature of the ink.

5. The method according to one of the preceding claims, wherein step b) is carried out in an atmosphere having a relative humidity not exceeding 30% or even 15%.

6. The method according to one of the preceding claims, wherein in step b), the printing is carried out so that each end of the negative pattern of said at least one microstructure of the microstructured device to be manufactured is located at the edge of the substrate, so that each end can, on the device to be manufactured, form an opening, such as a fluid inlet or outlet, so as to form a microstructure in the form of a channel.

7. The method according to the preceding claim, wherein, between the step b) and step c), the following sub-steps are performed:
- placing a microfluidic connection, partly at the region of the pattern which is intended to form a channel opening and partly outside the substrate; and
- applying the ink between said connection and the pattern.

8. The method according to one of the preceding claims, wherein, between the steps b) and c), annealing is performed, at a temperature advantageously between 10% and 80% of the melting temperature of the pattern.

9. The method according to one of the preceding claims, in which the step c) is carried out by casting the polymer onto the substrate printed by the pattern.

10. The method according to one of the preceding claims, wherein the polymer introduced in step c) is selected from: polydimethylsiloxane (PDMS), polyimides, agarose gels or an adhesive such as acrylic.

11. The method according to one of the preceding claims, wherein the additive present in the polymer is selected from a cross-linking agent, a photoinitiator or a solvent.

12. The method according to one of the preceding claims, wherein said polymer for forming the cover has a melting temperature strictly 110% of the sublimation or evaporation temperature of the ink forming the pattern.

13. The method according to one of the preceding claims, wherein the sublimation of step e) is carried out by heating and by applying a pressure differential between the inside of the assembly formed after step d) and the outside.

14. The method according to one of claims 1 to 16 wherein the liquefaction and subsequent evaporation of the ink in step e) is carried out by heating.

15. The method according to one of the preceding claims, wherein the ink is selected from:
- linear glycols with the generic empirical formula C₂ₙH₄ₙ+₂O₂ where n is a positive integer greater than or equal to 1, preferably such that n = 3, 4 or 5;
- cyclohexanediol;
- biphenyl;
- tri(cyclohexyl)methane;
- alcohols with the gross formula CₙH₂ₙ+₂O where n is a positive integer greater than or equal to 1, preferably such that n = 10, 11 or 12.

16. The method according to one of the preceding claims, wherein in the step b) a plurality of successive layers of ink are printed on top of each other.

17. The method according to one of the preceding claims, wherein the step b) is carried out by ink jet printing, using a printing nozzle and a liquid ink whose viscosity is less than or equal to 30 mPa.s⁻¹.

18. The method according to the preceding claim, wherein:
- the distance between, on the one hand, said printing nozzle and, on the other hand, the substrate is between 0.5 mm and 20 mm;
- the size of an ink drop ejected by said printing nozzle is between 10µm and 100µm;
- the frequency of ejecting ink drops from said nozzle is between 50Hz and 5kHz;
- the substrate on the one hand and said printing nozzle on the other hand being adapted to allow relative movement of one with respect to the other with a controlled relative movement speed of between 1mm/s and 100mm/s.

19. The method according to one of claims 1 to 16, wherein the step b) is performed by means of a syringe containing the ink.

20. The method according to the preceding claim, wherein:
- the distance between, on the one hand, an end of the syringe through which the ink is dispensed and, on the other hand, the substrate is between 0.1mm and 1mm;
- the flow rate of ink dispensed by the end of said syringe is between 0.01 nl/s and 10 nl/s;
- the substrate, on the one hand, and said syringe tip, on the other hand, being adapted to allow relative displacement of one with respect to the other with a controlled relative displacement speed of between 0.1mm/s and 10mm/s.
